# EUROPEAN PATENT APPLICATION

(11) **EP 2 869 302 A1**
(43) Date of publication of application: **06.05.2015**
(21) Application number: 14181069.7
(22) Date of filing: 14.08.2014
(51) Int. Cl.: G11C 13/00, G11C 13/02

(54) **Self-terminating write for a memory cell**

(30) Priority: 31.10.2013 US 201314068683
(71) Applicant: Honeywell International Inc., Morristown, NJ 07962-2245 (US)
(72) Inventor: Golke, Keith, Mroristown, NJ New Jersey 07962-2245 (US); Nelson, David K., Morristown, NJ New Jersey 07962-2245 (US)
(74) Representative: Houghton, Mark Phillip

(57) **Abstract**

A programmable impedance based memory device includes a programmable impedance element, read circuitry configured to determine a resistance of the programmable impedance element during a write operation; and, write circuitry configured to change the resistance of the programmable impedance element as part of performing the write operation, wherein the write circuitry is further configured to terminate the write operation based on the read circuitry detecting that the resistance of the programmable impedance element has passed a threshold value.

## Description

This invention was made with Government support under 09-C-0070 awarded by the U.S. Government. The Government has certain rights in the invention.

### TECHNICAL FIELD

This disclosure relates to memory devices and, more specifically, to non-volatile memory devices that use programmable impedance elements.

### BACKGROUND

Most modern electronic devices include a power source, components for storing data, components for processing data, components for receiving user input, and components for delivering user output. It is desirable for such electronic devices to have long battery life, powerful processing capabilities, and large amounts of data storage, but at the same time, it is also desirable for electronic devices to maintain small and lightweight form factors. To meet these conflicting demands, it is desirable for the components of these devices to become smaller with better performance.

It is generally desirable for memory components, for example, to store more data in a smaller space with faster read and write operations. Current types of non-volatile memory include electro-mechanical hard drives where read/write heads read and write data from and to a series of rotating disks. Other types of non-volatile memory include solid state memories that use transistors and other devices (e.g., capacitors, floating gate MOSFETs) to store data without any moving parts and with faster read and write access.

### SUMMARY

This disclosure generally describes techniques for writing data to a programmable impedance element based memory device, such as a carbon nanotube (CNT) memory device. The techniques may in some instances provide for faster and more precise read and write operations.

In one example, a method of performing write operations on a programmable impedance element based memory cell includes performing a write operation to change a resistance of a programmable impedance element; monitoring the resistance of the programmable impedance element during the write operation; and, in response to detecting that the resistance of the programmable impedance element has passed a threshold value, terminating the write operation.

In another example, a carbon nanotube based memory device includes a carbon nanotube (CNT) element; read circuitry configured to determine a resistance of the CNT element during a write operation; and, write circuitry configured to change the resistance of the CNT element as part of performing the write operation, wherein the write circuitry is further configured to terminate the write operation based on the read circuitry detecting that the resistance of the CNT element has passed a threshold value.

In another example, a programmable impedance element based memory device includes a programmable impedance element; read circuitry configured to determine a resistance of the programmable impedance element during a write operation; and, write circuitry configured to change the resistance of the programmable impedance element as part of performing the write operation, wherein the write circuitry is further configured to terminate the write operation based on the read circuitry detecting that the resistance of the programmable impedance element has passed a threshold value.

The details of one or more embodiments of the invention are set forth in the accompanying drawings and the description below. Other features, objects, and advantages of the invention will be apparent from the description and drawings, and from the claims.

### BRIEF DESCRIPTION OF DRAWINGS

FIG. 1 shows a circuit diagram of a carbon nanotube based memory cell that may be used to implement techniques of the present disclosure.
FIG. 2 shows a conceptual representation of the Rhigh and Rlow distribution of the CNT element as defined according to the current disclosure.
FIG. 3 shows a conceptual illustration of CNT element resistance oscillation when a constant high voltage is applied across it.
FIG. 4 shows a conceptual illustration of CNT element resistance change when writing with a constant write1 and write0 Tpulse which is not matched to one half the period of resistance oscillation (Tres_period) of the CNT element. Write operations (op) A-F are shown.
FIG. 5 shows a diagram of an array of CNT memory cells that may be used to implement the techniques of the present disclosure.
FIG. 6 shows a conceptual illustration of CNT element resistance change when writing to self-terminating reference resistances Rwrite1_ref and Rwrite0_ref. Write operations (op) A-F are shown.
FIG. 7 shows a flowchart of a method of performing write operations on a programmable impedance element based memory cell in accordance with the techniques of this disclosure.

### DETAILED DESCRIPTION

This disclosure describes a programmable impedance element based non-volatile memory device that includes circuitry to monitor the resistance of a programmable impedance element of the device during a write operation. An example of a programmable impedance element that retains the programmed impedance state when power is removed is a carbon nanotube (CNT) element. The techniques of this disclosure will at times be described with respect to a CNT element, but it should be understood that the techniques are generally applicable to any memory device that utilizes a programmable impedance element whose impedance is changed to define "0" and "1" data states whether that device retains the programmed state or not when power is removed. Examples of such devices may include Giant Magnetoresistance (GMR) resistors and Magnetic Tunneling Junctions (MTJ) used in Magnetoresistive RAMs (MRAM); Spin Transfer Torque devices used in Spin Transfer Torque RAMs (SPRAM); Chalcogenide resistors used in Phase Change RAMs (PCRAM); Metal oxide (MOx) devices used in Resistive Switching RAMs (RRAM); Programmable silver diffusion metallization cells (PMC) used in Conductive Bridging RAMs (CBRAM); any memristor type of device that can be placed in a Resistor RAM (ReRAM).

In contrast to typical CNT memory devices that perform a write operation by applying a voltage to a CNT element for a fixed duration of time, a CNT memory device of this disclosure applies a write condition for a non-fixed duration of time. By monitoring the resistance of the CNT element to determine when the CNT element has reached a desired resistance, a CNT memory device of this disclosure can terminate a write condition upon achieving a desired resistance in the CNT element, which as will be explained in more detail below, may improve device performance.

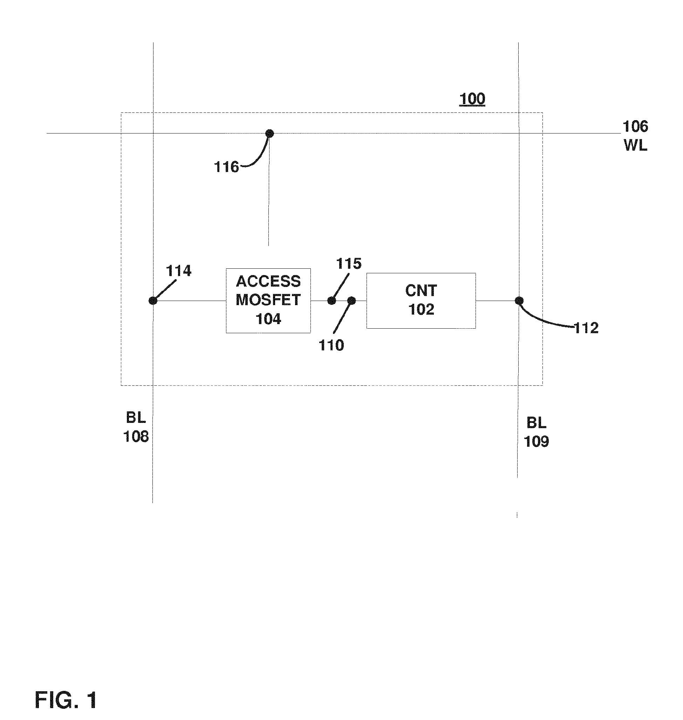

FIG. 1 is a circuit diagram of a carbon nanotube based memory cell 100 that may be used to implement techniques of this disclosure. Memory cell 100 may form part of a larger memory device that includes, for example, tens of billions of memory cells or more. Carbon nanotube memory cell 100 includes a CNT element 102, an access metal-oxide semiconductor field effect transistor (access MOSFET) 104 that can be turned "ON" and "OFF" to control access to CNT element 102, wordline (WL) 106, bitline (BL) 108, and bitline (BL) 109. CNT element 102 includes a first terminal 110 and a second terminal 112, and access MOSFET 104 includes a first terminal 114, a second terminal 115 and a third terminal 116. Bitline 109 connects to terminal 112 at a node, and bitline 108 connects to terminal 114 at a node. Wordline 106 connects to terminal 116 of access MOSFET 104 at a node and controls the turning "ON" and "OFF" of access MOSFET 104. Terminal 115 connects to terminal 110.

Terminal 116 corresponds to a gate of access MOSFET 104, and terminal 114 and terminal 115 correspond to the source and drain of access MOSFET 104. When the Wordline 106 voltage is set to a value that turns access MOSFET 104 "ON" current can flow through the MOSFET, the bitline 108 voltage is passed on to CNT element 102 terminal 110, and current is allowed to flow through CNT element 102. When Wordline 106 voltage is set to a value that turns access MOSFET 104 "OFF" current cannot flow through the MOSFET, the bitline 108 voltage is isolated from CNT element 102 terminal 110, and current is not allowed to flow through CNT element 102. The power source for this circuit (not shown in FIG. 1) provides the power supply voltage. This disclosure follows the convention that the more positive of the power supply nodes is labeled V_{DD}, and the more negative of the power supply nodes is labeled V_{SS}.

As used in this disclosure, the term node generally refers to a connection point where two or more terminals connect to one another or where one or more terminals connects to a line, such as bitline 108, bitline 109, or wordline 106. In FIG. 1, for example, terminal 115 of MOSFET 104 and terminal 110 of CNT element 102 connect at a node; terminal 116 of MOSFET 104 and wordline 106 connect at a node; terminal 114 of MOSFET 104 and bitline 108 connect at a node; and, terminal 112 of CNT element 102 and bitline 109 connect at a node. Typically, if a voltage is applied to a terminal or a line, then the same voltage is also applied to all terminals and lines of the same node. For instance, in the example of FIG. 1, if a voltage difference is applied to bitline 108 and bitline 109, then that same voltage difference is also applied to terminal 114 and terminal 112, which form nodes with bitline 108 and bitline 109 respectively. As another example, if a voltage is applied to wordline 106, then that same voltage is applied to terminal 116 which forms a node with wordline 106.

Memory cell 100 can be operated in a manner that stores a single bit of data (i.e. a "0" or "1"). The storage data state of memory cell 100 can be a function of the resistance value of CNT element 102. The resistance value of CNT element 102 can be considered programmable in the sense that it can be set to a desired value (i.e. high or low), and this desired value can be considered to represent a bit of digital data. For example, a high resistance value for CNT element 102 may correspond to a digital "0," and a low resistance value for CNT element 102 may correspond to a digital "1". The resistance value of CNT element 102 can be changed depending on the current and voltage applied to CNT element 102 across terminals 110 and 112. Typically, the resistance value of a CNT element can be written to the low resistance value that corresponds to a digital "1" or to the high resistance value that corresponds to a digital "0" as desired by applying a fixed voltage value for a fixed duration of time (i.e., pulse width time = Tpulse) to the CNT element. According to techniques of the current disclosure, however, instead of applying a voltage for a fixed duration of time to CNT element 102, the resistance value of CNT element 102 can be monitored while the voltage is being applied so that application of the voltage can be terminated upon achieving the desired resistance value for CNT element 102. Examples of how the resistance value for CNT element 102 may be monitored will be described in more detail below.

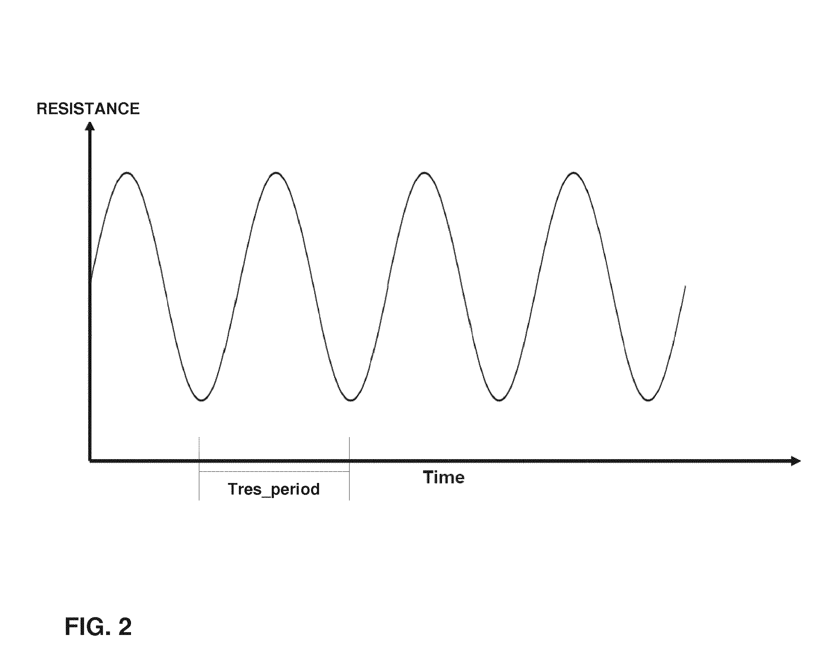

The empirically observed resistance change behavior of the CNT is as follows. If CNT element 102 is in a low resistance state, then applying a high voltage difference across terminals 110 and 112 results in a high current flow through CNT element 102. A high voltage with high current condition causes the resistance of CNT element 102 to increase. The increased resistance, however, lowers the current through CNT element 102 but the high voltage difference across terminals 110 and 112 is maintained. A high voltage with low current condition causes the resistance to decrease, taking CNT element 102 back to a low resistance state. Once the resistance is low again, the current through CNT element 102 once again increases, causing the resistance of CNT element 102 to once again increase. In this manner, the resistance of CNT element 102 oscillates between a high resistance state and a low resistance state with a time period of Tres_period when a high voltage difference is continuously applied across terminals 110 and 112. FIG. 2 conceptually shows this behavior.

FIG. 2 shows a conceptual representation of the Rhigh and Rlow distribution of the CNT element as defined according to the current disclosure. The transition time between the high and low resistance states is finite. By controlling the magnitude and duration of time (Tpulse) of the applied voltage across terminals 110 and 112, CNT element 102 can successfully be written to a "0" (i.e. changed from a low to a high resistance state) or written to a "1" (i.e. changed from a high to a low resistance state). Further, CNT element 102 can be successfully be written to a "1" (R_{low}) by limiting the current the applied voltage can supply to the CNT element to a low level (I_{low}) that is insufficient to cause a R_{low} to R_{high} change. If initially CNT element 102 is in a "0" (R_{high}) state, by limiting the current V_{high} can provide to I_{low}, after CNT element 102 has changed from R_{high} to R_{low}, the I_{low} limit prevents CNT element 102 from changing back to an R_{high} state and the Write "1" (R_{low}) operation is successfully completed. There is no current limiting approach that results in a successful Write "0" (R_{high}) operation since a high current is needed to produce the R_{low} to R_{high} state change. For purposes of explanation, this disclosure generally follows the convention that setting the resistance of CNT element 102 to a high resistance (i.e. low conductivity) state is a "write 0" operation or "write low" operation, while setting the resistance of CNT element 102 to a low resistance (i.e. high conductivity) state is a "write 1" or "write high" operation. Of course, these operations could also be logically reversed.

When reading CNT element 102, it is generally desirable to keep the resistance state of CNT element 102 unchanged. Thus, to read CNT element 102, a low voltage difference, which will not change the resistance value of CNT element 102, is applied across terminals 110 and 112 by applying a low voltage difference across bitline 108 and bitline 109, and the resulting current through CNT element 102 can be measured by other circuitry. Based on the measured current and the voltage across bitline 108 and bitline 109, and having an access MOSFET with a resistance that is much less than the resistance value of CNT element 102, the resistance of CNT element 102 can be determined to be either high or low. Depending on whether the resistance of CNT element 102 is high or low, it can be determined if the value of memory cell 100 is a digital "0" or digital "1." As will be explained in greater detail below, the desired read condition for reading a resistance value of CNT element 102 and the desired write conditions for changing a resistance value of CNT element 102 can be achieved based on the voltages applied to wordline 106, bitline 108, and bitline 109.

The terms high resistance (R_{high}), low resistance (R_{low}), high voltage (V_{high}), low voltage (V_{low}), high current (I_{high}), and low current (I_{low}) are generally meant to be relative terms. A high resistance value, for example, is greater than a low resistance value (R_{high} > R_{low}). The terms are not meant to imply specific resistances, voltages, or currents of any specific values.

When multiple nodes are defined to have a V_{high} for a given operating condition, the voltage values may or may not be the same on the different nodes. When different operating conditions are defined to have a V_{high}, the voltage values may or may not be the same as in other operating conditions. When multiple nodes are defined to have a V_{low} for a given operating condition, the voltage values may or may not be the same on the different nodes. When different operating conditions are defined to have a V_{low}, the voltage values may or may not be the same as in other operating conditions. V_{DD} and V_{SS} values can be applied to nodes by either direct connection to the V_{DD} and V_{SS} nodes or driven to V_{DD} and Vss values through circuitry. A means to create Vhigh > V_{DD} can be achieved by using a charge pump circuit. A means to create V_{DD} > Vlow > V_{SS} can be achieved by using a reference voltage (V_{ref}) generating circuit which typically contain a bandgap circuit. Both the charge pump and V_{ref} circuits are commonly known in the integrated circuit industry. As examples, in some implementations where V_{DD} = 5V, a low voltage for reading CNT element 102 may be approximately 1V while a high voltage for writing to CNT element 102 may be approximately 6-8V. A high resistance value corresponding to a "0" or low state may be approximately 10-100 giga-ohms, while a low resistance value corresponding to a "1" or a high state may be approximately 10-100 kilo-ohms. An "ON" access MOSFET impedance may be approximately 1-10 kilo-ohms. These ranges of voltages and resistances, however, are merely examples, as the memory devices of the present disclosure can be configured to operate over other ranges of voltages and resistances.

The difference between the high resistance (Rhigh) and low resistance (Rlow) states needs to be large enough to ensure there is no overlap between the Rhigh and Rlow distributions. The read reference resistance (Rread_ref) to determine if the resistance state is high or low is set between these two distributions. In other words the requirements are:
Rlow distribution max (Rlow_max) < Rhigh distribution min (Rhigh_min)
Rlow_max < Rread_ref < Rhigh_min
As will be explained in more detail below, when reading the value of CNT element 102, a resistance value greater than Rread_ref means memory cell 100 is storing a "low" or a 0, and a resistance value less than Rread_ref means memory cell 100 is storing a "high" or a 1. Higher CNT element resistance values typically require longer read and write times which can be undesirable for high performance applications. The tighter the Rlow and Rhigh distributions are the smaller the difference between Rlow_min and Rhigh_max. This in turn allows reducing the value of Rhigh_max.

According to the techniques of this disclosure, a successful write operation can be achieved by controlling the magnitude and time duration of the applied voltage and current to CNT element 102. Duration of time control can be critical in setting the resistance of a CNT element to the desired resistance because if a high voltage with unlimited current is applied continuously, it is possible for CNT element 102 to oscillate between high and low resistance states with a time period of Tres_period as shown in FIG. 2. However, it is believed that there is a distribution of Tres_period among a population of CNT elements and it has been found that not all CNT elements properly respond to the same imposed duration of time that the write0 and write1 voltage pulse width is applied, resulting in less than desirable write yield. Further, the resistance variation of those CNT elements that successfully change state can be very large.

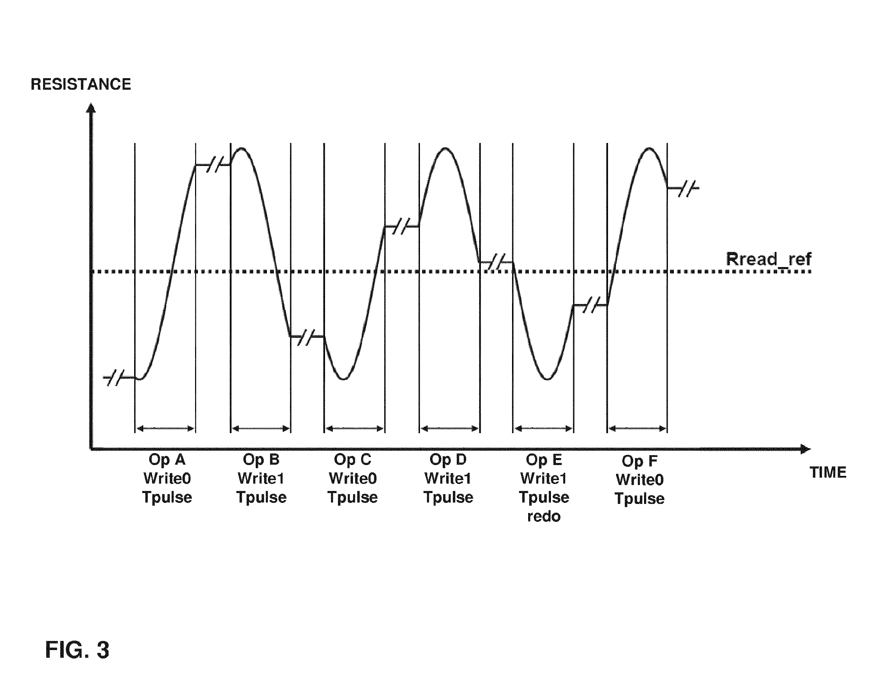

FIG. 3 conceptually illustrates where a write operation occurs between the vertical lines labeled op*write*Tpulse and the angled parallel lines represent the passage of some amount time between write operations (This time can be can be long or short, the same or different for each set of angled parallel lines). FIG. 3 shows a conceptual illustration of CNT element resistance oscillation when a constant high voltage is applied across it. During the write operation on the CNT element its resistance is changing. When there is no write operation on the CNT element its resistance is constant. FIG. 3 shows a conceptual illustration of CNT element resistance change when writing with a constant write1 and write0 Tpulse that is not matched to one half the period of resistance oscillation (Tres_period) of the CNT element. One possible outcome is the case of operation D (op D) where write1 did not sufficiently move the resistance past Rread_ref resulting in the need to redo operation D at operation E (op E). Further, the resulting distribution of resistance values after successful writes is large.

Instead of trying to get all CNT elements in all the memory cells of a CNT device, as well as all CNT devices themselves, to be sufficiently uniform so that a high enough percentage of memory cells will operate within predefined Write0 and Write1 voltage, current, and pulse width duration conditions, this disclosure describes techniques for customizing the write pulse width duration to each individual CNT element's characteristic behavior to achieve a desired resistance state. Accord to techniques of this disclosure, this may be accomplished by performing a read operation during the write operation and then terminating the write operation when the read determines that the desired CNT resistance has been reached. That is, while the Write condition is being applied to memory cell 100, circuitry can monitor the resistance of CNT element 102 as it changes. Once the resistance of CNT element 102 changes to a predefined desired amount, the write condition can be terminated. When implementing the techniques of this disclosure, if a resistance of CNT element 102 is already in the desired state, the write condition may immediately terminate and an unnecessarily long application of the write conditions may be avoided.

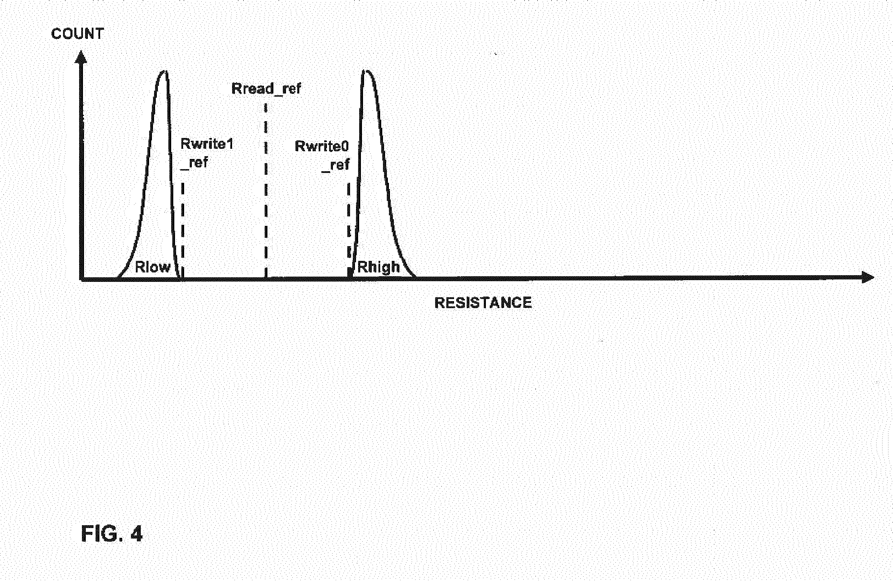

FIG. 4 shows a conceptual representation of the Rhigh and Rlow distribution as defined according to the current disclosure. FIG. 4 shows a resistance value on the x-axis and a CNT element count on the y-axis. Rread_ref represents the resistance value used to determine if CNT element 102 is in a high resistance state or a low resistance state. Resistance values lower than Rread_ref are considered to correspond to a low resistance state, while Resistance values higher than Rread_ref are considered to correspond to a high resistance state. As previously introduced, this disclosure describes techniques for monitoring a resistance value and terminating a write operation when a CNT element resistance is sufficiently low for a write high or write1 operation or sufficiently high for a write low or write0 operation. Rwrite0_ref is an example of a resistance value at which a write low/write0 operation may be terminated when CNT element resistance is determined to be >Rwrite0_ref, and Rwrite1_ref is an example of a resistance value at which a write high/write1 operation may be terminated when CNT element resistance is determined to be <Rwrite1_ref. As will be explained in more detail below, a device operating in accordance with the techniques of this disclosure can include circuitry to compare the resistance value of a CNT element to Rwrite1_ref and Rwrite0_ref and terminate write operations based on the comparison.

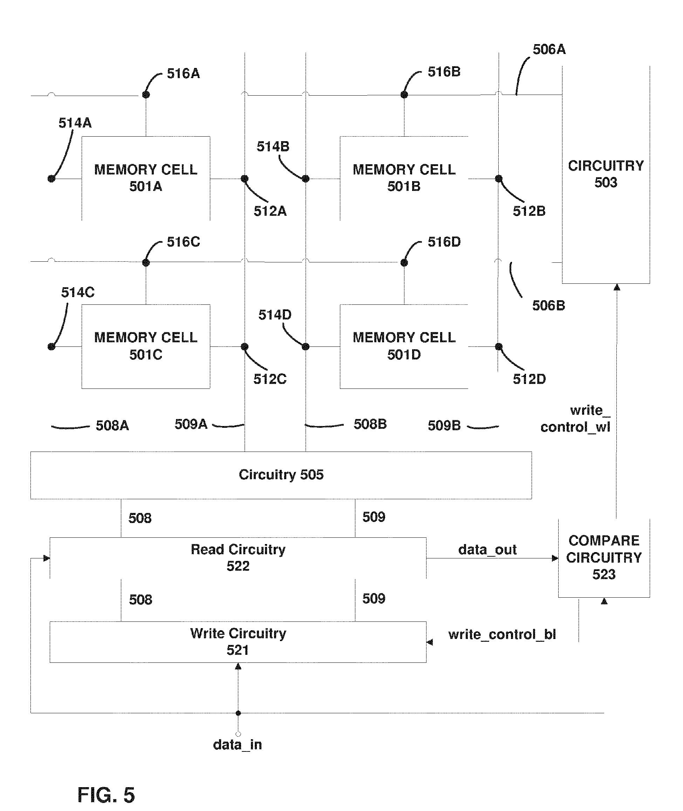

FIG. 5 shows a diagram of an array of memory cells 501A-D. Memory cell 501A, memory cell 501B, memory cell 501C, and memory cell 501D may each have structure and function similar to memory cell 100 of FIG. 1. FIG. 5 also shows wordline driver and row decode circuitry (circuitry 503), column decode circuitry (circuitry 505), write circuitry 521, read circuitry 522, and compare circuitry 523. Circuitry 503 controls wordline 506A and wordline 506B. Wordline 506A connects to memory cell 501A at node 516A and connects to memory cell 501B at node 516B. Wordline 506B connects to memory cell 501C at node 516C and connects to memory cell 501D at node 516D. Although, not explicitly shown in FIG. 5, each of nodes 516A-D may correspond to a gate of an access MOSFET as described in relation to access MOSFET 104 of memory cell 100 of FIG. 1. Memory cells 501A-D include an access MOSFET, nodes 514A-D each correspond to a source or drain terminal of an access MOSFET and nodes 512A-D each correspond to a terminal of a CNT element.

FIG. 5 shows, for purposes of explanation, a 2-by-2 array of four memory cells, but an actual memory device may include an array of memory cells with tens of billions of individual memory cells or even more. Memory devices implementing one or more of the techniques described in this disclosure may be implemented in a wide array of electronic devices ranging from small portable devices such as music players, smart phones, game cartridges, and memory sticks up to larger devices such as tablet computers, gaming devices or consoles, desktop computers, super computers, and enterprise storage solutions.

Bitline 508A connects to memory cell 501A at node 514A and connects to memory cell 501C at node 514C. Bitline 508B connects to memory cell 501B at node 514B and connects to memory cell 501D at node 514D. Although, not explicitly shown in FIG. 5, each of nodes 514A-D may correspond to a source or drain terminal of an access MOSFET as described in relation to access MOSFET 104 of memory cell 100 of FIG. 1.

Bitline 509A connects to memory cell 501A at node 512A and connects to memory cell 501C at node 512C. Bitline 509B connects to memory cell 501B at node 512B and connects to memory cell 501D at node 512D. Although, not explicitly shown in FIG. 5, each of nodes 512A-D may correspond to a terminal of a CNT element as described in relation to CNT element 102 of memory cell 100 of FIG. 1.

By controlling the voltages applied to wordline 506A, wordline 506B, bitline 508A, bitline 508B, bitline 509A, and bitline 509B, the CNT elements of individual memory cells can be addressed. For example, suppose that a write operation is being performed on memory cell 501A. Circuitry 503 may apply an access MOSFET turn-on voltage to wordline 506A and a turn-off voltage to 506B, and circuitry 505 may pass a high voltage from node 509 to bitline 509A but not to 509B and pass a source voltage from node 508 to bitline 508A but not to 508B. In this case, the turn-on voltage applied to wordline 506A causes node 516516A (connected to a gate of an access MOSFET, not shown in FIG. 5) to receive a turn-on voltage. The high voltage applied to bitline 509A causes node 512A (connected to a terminal of a CNT element, not shown in FIG. 5) to receive a high voltage, and the source voltage applied to bitline 508A causes node 514A (connected to a source or drain of an access MOSFET) to receive a source voltage. As described above, the high voltage applied to node 516A causes current to flow through an access MOSFET, resulting in a current flow through and a high voltage drop across the CNT element of memory cell 501A. Thus, the resistance of the CNT element 501A can be changed.

While this write operation is occurring at memory cell 501A, it is intended that memory cells 501B, 501C, and 501D remain unchanged. Although the high voltage applied to wordline 506A can cause a high voltage at node 516B (connected to a gate of an access MOSFET in memory cell 501B), circuitry 505 may not apply a high voltage to either bitline 508B or 509B. In this case, with no high voltage drop across its CNT element, the state of memory cell 501B does not change.

Similarly, while this write operation is occurring at memory cell 501A, the high voltage applied to bitline 509A causes a high voltage at node 512C, and the source voltage applied to bitline 508A causes a source voltage at node 514C. Circuitry 503, however, applies a turn-off voltage to wordline 506B. Thus, the access MOSFET of memory cell 501C does not conduct current, and thus it is intended that this prevents current flow through the CNT element of memory cell 501C. Without a current flow, the resistance of the CNT element does not change, and the state of memory cell 501C does not change. Accordingly, by controlling the voltages applied to wordline 506A, wordline 506B, bitline 508A, bitline 508B, bitline 509A, and bitline 509B, in the manner described above, memory cells 501A, 501B, 501C, and 501D can be written to individually without altering the state of memory cells that are connected to a common wordline or common bitline.

Write circuitry 521 receives data input (definition of the 1 or 0 data state to be written into the memory cell), which represents either a write high or a write low operation for a particular memory cell. Depending on the data state to be written Write circuitry 521 defines the appropriate voltage to be applied to the bitlines. As discussed above, circuitry 505 controls the passing of the voltages from write circuitry 521 output nodes 508 and 509 to the various bitlines so that the write operation is applied to the correct memory cell within the array of memory cells.

Read circuitry 522 is configured to monitor the resistance of the memory cell while it is undergoing a write operation. This monitoring of the resistance is termed Rmonitor, which represents the real time measuring of the CNT element resistance during the write operation. It uses the write "0" or "1" states defined on data_in to determine which monitoring state and Rwrite_ref to set up.
For example:
IF data_in = 1 (i.e., performing a write1 operation) set Rwrite_ref = Rwrite1_ref,
IF Rmonitor ≤ Rwrite1_ref THEN set data_out = 1 ELSE set data_out = 0;
IF data_in = 0 (i.e., performing a write0 operation) set Rwrite_ref = Rwrite0_ref,
IF Rmonitor ≥ Rwrite0_ref THEN set data_out = 0 ELSE set data_out = 1.

Comparing Rmonitor to Rwrite_ref to determine if Rmonitor is ≤(≥) Rwrite1(0)_ref is not done by directly comparing resistance values. Rather, Read circuitry 522 converts Rmonitor and Rwrite1(0)_ref to either a voltage or current to make the comparison. Read circuitry 522 may, for example, monitor the resistance of the CNT element in the memory cell undergoing the write operation by comparing the current sourced or sunk by the write circuitry (i.e., Icnt) to the memory cell through nodes 508 or 509 to the current through the Rwrite1(0)_ref that occurs when the same high voltage applied across the memory cell is applied across Rwrite1(0)_ref (i.e., Iwrite1(0)_ref). By comparing Icnt and Iwrite1(0)_ref, read circuitry 522 can determine when the resistance of the CNT element in the memory cell is equal to or passes Rwrite1(0)_ref. Note Iwrite1(0)_ref can be defined in other ways than with Rwrite1_ref and Rwrite0_ref resistor devices. One approach is to use current reference and current mirror circuit techniques to define the desired Iwrite1(0)_ref. In the example of FIG. 5, read circuitry 522 is configured to pass the determined "0" or "1" data state of the CNT element in the memory cell to compare circuitry 523 via node data_out.

Compare circuitry 523 compares the "0" or "1" data state of the selected CNT element of memory cells 501A-D, as determined by read circuitry 522 and defined on node data_out, to the "0" or "1" data state as defined on node data_in and issues a write terminate instruction on the write_control_b1 and write_control_w1 lines upon determining that the data states on data_in and data_out match

When circuitry 523 issues a write terminate command on write_control_b1 to write circuitry 521, write circuitry 521 terminates the application of the high voltage on nodes 508 or 509 which causes the high voltage across the selected memory cell to collapse which will stop the resistance changing in the CNT element. When circuitry 523 issues a write terminate command on write_control_w1 to circuitry 503, circuitry 503 changes the turned-on wordline to turned-off which causes the current through the selected memory cell to collapse which will stop the resistance changing in the CNT element. Note either the write terminate command to write circuitry 521 or the write terminate command to circuitry 503 by itself as described above is sufficient to stop the resistance changing in the CNT element.

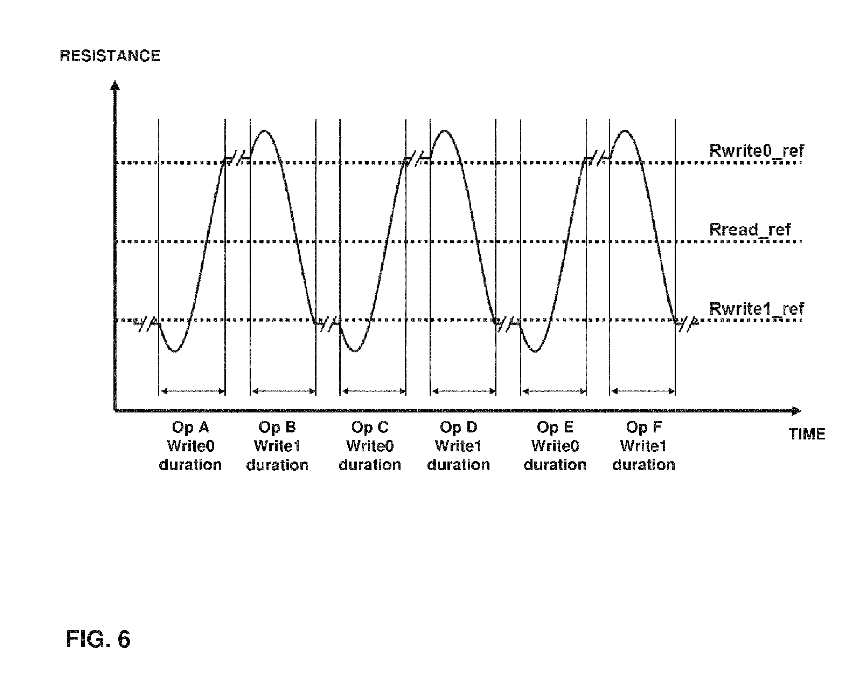

FIG. 6 illustrates the CNT element resistance behavior from the described operation where a write operation occurs between the vertical lines labeled op*write*duration and the angled parallel lines represent the passage of some amount time between write operations (This time can be can be long or short, the same or different for each set of angled parallel lines.). During the write operation on the CNT element its resistance is changing. When there is no write operation on the CNT element its resistance is constant. FIG. 6 shows a conceptual illustration of CNT element resistance change when writing to a self-terminating Rwrite1_ref and Rwrite0_ref. Note this results in a reliable resistance change and tight distributions of Rwrite0 and Rwrite1 values independent of the period of resistance oscillation (Tres_period) of the CNT element.

According to the techniques of this disclosure, read circuitry 522 can monitor the resistance of a CNT element of a CNT memory cell and determine the data state of the CNT element during the applied write condition. Compare circuitry 523 can then use the CNT element data state information from read circuitry 522 to determine when the CNT element has reached the desired data state and to then terminate the write condition. In general, this disclosure describes a self-terminating write for a memory cell by doing a read during the write of a memory cell and when the memory cell achieves the desired state it self-terminates the write.

When using the techniques of this disclosure, there may be no need to limit the current applied to the CNT element for either Write0 or Write 1 operations. When using the techniques of this disclosure, there may also not be a need to impose a "one size fits all" Vhigh pulse width duration to the CNT element for either Write0 or Write 1 operations because the Vhigh pulse width duration can be defined automatically and be tailored specifically to the characteristics of each CNT element. Accordingly, implementing the techniques of this disclosure may result in a smaller distribution of Rlow and a known Rlow_max of <Rwrite1_ref and result in a smaller distribution of Rhigh and a known Rhigh_min of >Rwrite0_ref.

The techniques of this disclosure may also allow for defining specific resistance values for Rlow_max and Rhigh_min and allow for reducing the values of and the separation between Rlow_max and Rhigh_min, which may in turn allow for Rread_ref to be reduced. In some instance it may even be possible to have Rlow_max = Rread_ref = Rhigh_min. Reductions in Rlow_max, Rhigh_min and Rread_ref may reduce sensitivity to leakage currents on the bitlines. It also may reduce the RC delay to the bitlines which in turn reduces read and write times.

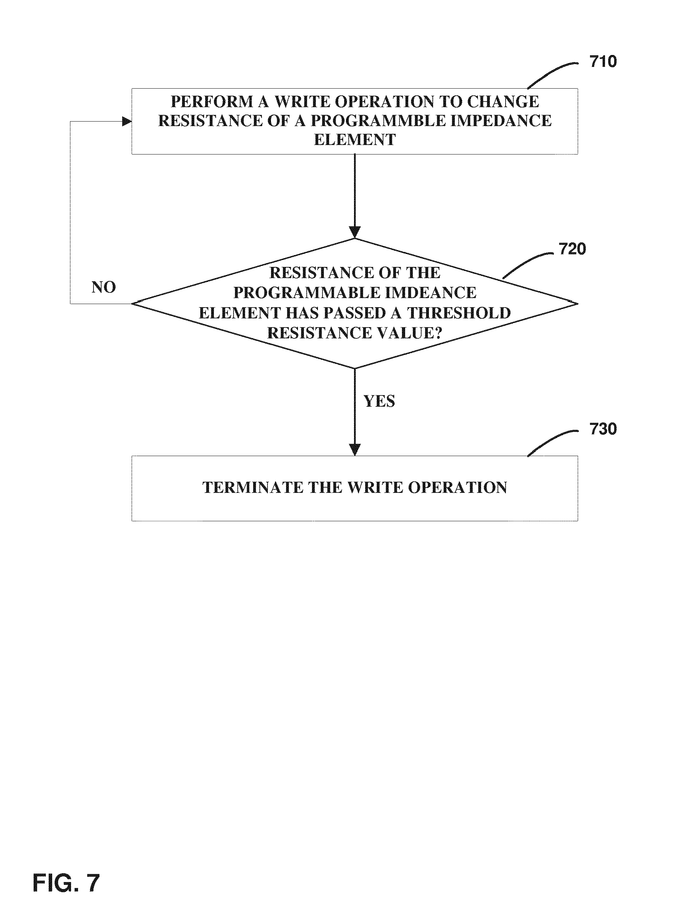

FIG. 7 shows a flowchart of a method of performing write operations on a programmable impedance element based memory cell in accordance with the techniques of this disclosure. The method of FIG. 7 may, for example, be performed by a programmable impedance element based memory device, including the CNT device described above with respect to FIG. 5. The device performs a write operation to change a resistance of a programmable impedance element (710). The device can perform the write operation by applying a voltage to the programmable impedance element for a non-fixed duration of time. The device can monitor the resistance of the programmable impedance element (720) while the write operation is performed, and in response to detecting that the resistance of the programmable impedance element has passed a threshold resistance value (420, yes), the device can terminate the write operation (730). In response to detecting that the resistance of the programmable impedance element has not passed the threshold resistance value (720, no), the device can continue to perform the write operation (710). To detect that the resistance of the programmable impedance element has passed the threshold value, the device can compare the resistance of the programmable impedance element to the threshold value. If the write operation is a write high operation, then the device can detect that the resistance of the programmable impedance element has passed the threshold value by detecting that the resistance of the programmable impedance element is lower than the threshold value. If the write operation is a write low operation, then the device can detect that the resistance of the programmable impedance element has passed the threshold value by detecting that the resistance of the CNT element is higher than the threshold value. The device can perform the write operation and monitor the resistance of the programmable impedance element simultaneously or substantially simultaneously.

Various embodiments of the invention have been described. These and other embodiments are within the scope of the following claims.

## Claims

1. A method of performing write operations on a programmable impedance element based memory cell, the method comprising:
performing a write operation to change a resistance of a programmable impedance element;
monitoring the resistance of the programmable impedance element during the write operation;
in response to detecting that the resistance of the programmable impedance element has passed a threshold value, terminating the write operation.

2. The method of claim 1, wherein detecting that the resistance of the programmable impedance element has passed the threshold value comprises comparing the resistance of the programmable impedance element to the threshold value.

3. The method of claim 1, wherein the write operation comprises a write high operation, and wherein detecting that the resistance of the programmable impedance element has passed the threshold value comprises detecting that the resistance of the programmable impedance element has passed a predefined resistance threshold value that defines a high state.

4. The method of claim 1, wherein the write operation comprises a write low operation, and wherein detecting that the resistance of the programmable impedance element has passed the threshold value comprises detecting that the resistance of the programmable impedance element has passed a predefined resistance threshold value that defines a low state.

5. The method of claim 1, wherein performing the write operation and monitoring the resistance of the programmable impedance element are performed simultaneously.

6. The method of claim 1, wherein performing the write operation comprises applying a voltage to the programmable impedance element for a non-fixed duration of time.

7. The method of claim 1, wherein monitoring the resistance of the programmable impedance element comprises measuring a current flow through the programmable impedance element and determining the resistance of the CNT element based on the measured current.

8. The method of claim 1, wherein detecting that the resistance of the programmable impedance element has passed the threshold value comprises comparing a current flow through the programmable impedance element to a reference current.

9. The method of claim 1, wherein the programmable impedance element comprises a carbon nanotube.

10. A carbon nanotube based memory device, the device comprising:
a carbon nanotube (CNT) element;
read circuitry configured to determine a resistance of the CNT element during a write operation;
write circuitry configured to change the resistance of the CNT element as part of performing the write operation, wherein the write circuitry is further configured to terminate the write operation based on the read circuitry detecting that the resistance of the CNT element has passed a threshold value.

11. The device of claim 10, further comprising:
compare circuitry, wherein the compare circuitry is configured to compare the resistance of the CNT element to the threshold value.

12. The device of claim 10, wherein the write operation comprises a write high operation, and detecting that the resistance of the CNT element has passed the threshold value comprises detecting that the resistance of the CNT element has passed a predefined resistance threshold value that defines a high state.

13. The device of claim 10, wherein the write operation comprises a write low operation, and wherein detecting that the resistance of the CNT element has passed the threshold value comprises detecting that the resistance of the CNT element has passed a predefined resistance threshold value that defines a low state.

14. The device of claim 10, wherein the write circuitry and the read circuitry are configured to operate simultaneously.

15. The device of claim 10, wherein the write circuitry performs the write operation by applying a voltage to the CNT element for a non-fixed duration of time.
